# FASCICULE DE BREVET EUROPEEN

(11) **EP 1 702 085 B1**
(45) Date de publication et mention de la délivrance du brevet: **28.04.2010**
(21) Numéro de dépôt: 04816528.6
(22) Date de dépôt: 10.12.2004
(51) Int. Cl.: C23C 2/40

(54) **DISPOSITIF POUR DEPOSER UNE COUCHE DE SILICIUM POLYCRISTALLIN SUR UN SUPPORT**
VORRICHTUNG ZUR ABSCHEIDUNG EINER SCHICHT AUS POLYKRISTALLINEM SILICIUM AUF EINEM TRÄGER
DEVICE FOR DEPOSITING A POLYCRYSTALLINE SILICON LAYER ON A SUPPORT

(30) Priorité: 24.12.2003 FR 0351203
(43) Date de publication de la demande: 20.09.2006
(73) Titulaire: Solarforce, 69760 Limonest (FR)
(72) Inventeur: BELOUET, Christian, F-92330 Sceaux (FR); REMY, Claude, F-69760 Limonest (FR)
(74) Mandataire: Lenne, Laurence
(86) Numéro de dépôt international: PCT/FR2004/050674
(87) Numéro de publication internationale: WO 2005/064034

(56) Documents cités:
- WO-A-01/04388
- FR-A- 2 386 359
- FR-A- 2 550 965
- US-A- 4 616 595

## Description

La présente invention concerne un dispositif pour déposer une couche de silicium polycristallin sur un support mobile allongé sensiblement plan, du type comportant un creuset contenant un bain de silicium fondu, un support plongé au moins partiellement dans le bain et traversant sensiblement verticalement, dans le sens de la longueur du support, la surface d'équilibre du bain.

Dans un dispositif connu de ce type, par exemple décrit dans le document FR2386359, le fond du creuset comporte une fine ouverture par laquelle le support, qui est un ruban de carbone, pénètre dans le bain et le traverse verticalement en circulant de bas en haut.

Cependant, on constate que l'épaisseur de la couche de silicium déposée sur les faces du ruban décroît rapidement lorsqu'on s'approche des deux bords latéraux du ruban. Il en résulte que la couche de silicium déposée présente, le long de ces deux bords latéraux, respectivement deux bandes latérales dont les caractéristiques physiques sont détériorées par rapport à celles de la partie médiane de la couche. Ces bandes latérales sont pratiquement inutilisables notamment pour réaliser des cellules photovoltaïques et sont des sources de fractures dans les couches de silicium.

En effet, sur les bords du ruban de carbone, le ménisque de silicium liquide passe d'une géométrie bidimensionnelle avec une ligne de raccordement solide-liquide située à environ 6,8 mm au-dessus du bain à une géométrie de révolution. Dans ce dernier cas, la ligne de raccordement solide-liquide, fonction au premier ordre de l'épaisseur du ruban de carbone en l'absence de moyens de contrôle particuliers, est située à une hauteur très faible au-dessus du bain. Dans la zone de « transition » jusqu'au bord du ruban, soit sur une largeur de l'ordre de 5mm, la ligne de raccordement solide-liquide s'abaisse de 6,8 mm à typiquement 1-2 mm. Dans cette zone, l'épaisseur du dépôt décroît rapidement. Le dépôt devient fragile et sa qualité cristalline se dégrade (grains de petite dimension).

Pour tenter de contrôler les bords, un dispositif divulgué dans le document FR2550965 comporte en outre deux goulottes à section semi-circulaire maintenues verticalement respectivement de part et d'autre des deux bords latéraux du ruban traversant le bain. La concavité des deux goulottes est tournée vers les deux bords latéraux respectifs du ruban, Ces goulottes étant partiellement plongées dans le bain de façon à élever son niveau par capillarité au voisinage des bords latéraux du ruban.

Pour contrôler la montée capillaire du silicium liquide le long des goulottes, les paramètres suivants sont à faire varier: diamètre intérieur des goulottes, distance et orientation des goulottes par rapport aux bords du ruban.

Certes, ce dernier dispositif permet de réaliser des dépôts de silicium sur un ruban de carbone avec une surface utile de dépôt augmentée, présentant moins de fractures, et avec des propriétés électriques des couches de silicium déposées améliorées.

Toutefois, ce dispositif n'est pas encore optimisé. L'élévation de la ligne de raccordement solide-liquide sur les bords reste faible, la zone de transition encore trop large. En outre, la réduction d'épaisseur sur les bords reste importante et cette zone reste source de génération de fractures au cours du refroidissement puis des manipulations ultérieures du ruban.

L'objectif de l'invention est de contrôler davantage l'épaisseur et la qualité du dépôt sur les bords du support, de préférence par des moyens fiables et simples à l'échelle industrielle.

A cet effet, l'invention propose un dispositif pour déposer une couche à base de silicium polycristallin sur un support mobile, allongé, sensiblement plan, et comprenant deux faces longitudinales et deux bords latéraux longitudinaux, comprenant :
- un creuset contenant un bain de silicium fondu, ledit support étant destiné à être plongé au moins partiellement dans le bain et à traverser sensiblement verticalement dans le sens de la longueur la surface d'équilibre du bain,
- au moins un élément de contrôle des bords, chaque élément de contrôle des bords étant maintenu sensiblement verticalement à proximité de l'un des deux bords latéraux longitudinaux,
   chaque élément de contrôle des bords comprenant des parois délimitant une ouverture longitudinale bordant le bord latéral longitudinal correspondant, chaque ouverture étant partiellement plongée dans le bain de façon à élever le niveau du bain par capillarité à proximité du bord latéral longitudinal correspondant,
**caractérisé en ce que** au moins une des parois, dite d'insertion, partiellement en regard d'une des faces longitudinales, est sensiblement plane.

Par contrôle des bords, on entend étendre les conditions de la croissance dans les parties latérales le plus près possible des bords : Maintien de l'épaisseur et de la texture cristalline du dépôt

L'ouverture selon l'invention est plus aisément ajustable que l'ouverture semi-circulaire de l'art antérieur. En effet, au lieu d'ajuster le diamètre intérieur d'une ouverture semi-circulaire, on peut ajuster indépendamment plusieurs paramètres : l'écartement des parois, la longueur de chaque paroi d'insertion, voire même la forme d'une paroi « de fond » (courbée ou également plane).

La présence d'un élément de contrôle des bords agit sur la température dans la nappe liquide au voisinage immédiat du bord correspondant du support en modifiant localement les échanges thermiques dans le bain et dans une certaine mesure dans le support (échange radiatif avec l'extérieur modifié par la présence des éléments).

Par ailleurs, la forme de la surface externe de l'élément de contrôle, située du coté opposé à l'ouverture peut aussi être choisie librement.

Le dispositif selon l'invention comprend avantageusement deux éléments de contrôle des bords, chaque élément de contrôle des bords comprenant deux parois d'insertion sensiblement planes. Un tel dispositif permet d'élever le niveau du bain sur chaque face longitudinale du support et à chaque bord latéral longitudinal.

La présente invention n'est toutefois pas limitée par un nombre de parois d'insertion égal à quatre. Un dispositif selon l'invention peut par exemple comprendre un seul élément de contrôle des bords à une seule paroi d'insertion en regard d'une des faces longitudinales et sensiblement plane.

De préférence, les parois d'insertion peuvent être soit parallèles soit évasées vers l'extérieur.

Avantageusement, la profondeur moyenne de chaque ouverture peut être inférieure à 1 cm et, par ailleurs, l'écartement moyen entre les parois d'insertion peut être inférieur à 7 mm. De telles caractéristiques ne sont bien entendu pas limitatives.

Dans un premier mode de réalisation, le creuset comportant un fond et des parois latérales, chacun des éléments de contrôle des bords est fixe et maintenu verticalement par le fond. Le maintien peut par exemple être effectué par vissage. La présente invention n'est bien entendu pas limitée par la manière dont le maintien est mis en oeuvre.

Dans ce premier mode de réalisation, les éléments de contrôle des bords ne sont pas déplaçables. Cela est particulièrement adapté pour une production où le tirage est automatique voire sans surveillance. En outre, un tel dispositif est robuste et stabilisé.

En outre, chacun des éléments de contrôle des bords peut s'étendre longitudinalement jusqu'au fond et de préférence former une structure monolithique avec le fond. Chacun des éléments de contrôle des bords peut aussi présenter au moins un orifice plongé dans le bain et apte à l'alimentation en silicium dudit élément, afin de permettre d'alimenter le bain sur les bords. L'orifice est de préférence millimétrique et situé au voisinage du fond.

Dans un deuxième mode de réalisation, chacun des éléments de contrôle des bords comprend une plaquette avec ladite ouverture, laquelle est amenée au contact de la surface d'équilibre du bain.

Le contact de la surface du bain peut être de préférence effectué par une liaison entre la plaquette et des moyens de déplacement extérieurs au creuset et de préférence autorisant uniquement un déplacement vertical.

De préférence, chaque plaquette comprend un disque avec ladite ouverture et qui peut présenter un diamètre effectif supérieur à 10 mm et de préférence de l'ordre de 12 mm,

Par ailleurs, dans ce deuxième mode, l'écartement moyen entre les parois d'insertion peut être de l'ordre de 2 mm.

Chacun des éléments de contrôle des bords peut être à base d'un matériau non réactif au silicium de préférence choisi parmi le graphite, le carbure de silicium et le nitrure de silicium.

Les éléments de contrôle des bords peuvent présenter de préférence une émissivité supérieure à l'émissivité du silicium.

Ces caractéristiques ne sont bien entendu pas limitatives.

D'autres caractéristiques et avantages de la présente invention apparaîtront dans la description suivante de modes de réalisation de l'invention donnés à titre illustratif et nullement limitatif.

Dans les figures suivantes :
- la figure 1 représente schématiquement un premier mode de réalisation du dispositif selon l'invention, en vue de dessus,
- la figure 2 représente schématiquement dans l'espace le dispositif de la figure 1, coupé suivant un plan vertical,
- la figure 3 représente schématiquement un deuxième mode de réalisation du dispositif selon l'invention, coupé suivant un plan vertical,
- et la figure 4 représente schématiquement un troisième mode de réalisation du dispositif selon l'invention, en vue de dessus.

Dans ce qui suit, les éléments identiques ou analogues (fonction et/ou structure) sont désignés par le mêmes références dans tous les modes de réalisation de l'invention.

Les figures présentées ne sont pas à l'échelle.

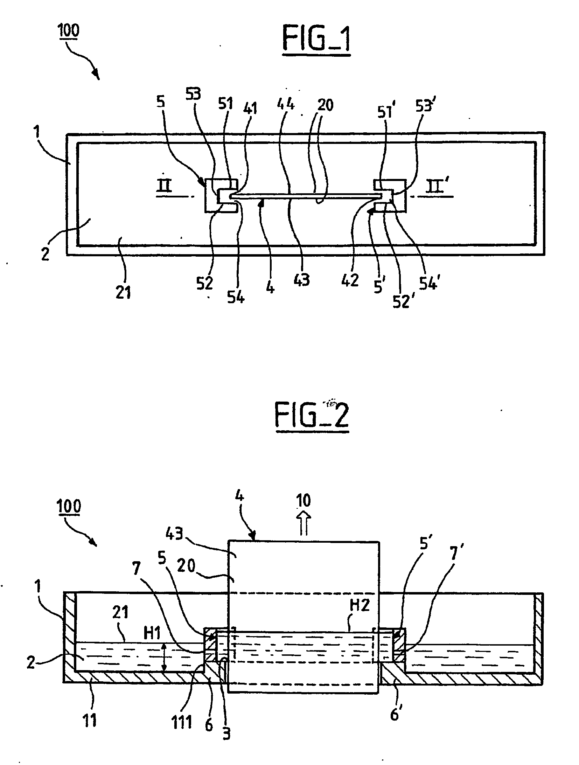

Sur les figures 1 et 2 est représenté un premier dispositif 100 pour déposer une couche à base de silicium polycristallin sur un support mobile allongé sensiblement plan.

Ce dispositif 100 comporte un creuset 1 parallélépipédique en graphite et contenant un bain 2 de silicium fondu. Le fond 11 du creuset comporte une nervure verticale 111 de section transversale rectangulaire qui délimite une fine ouverture linéaire 3 à travers laquelle passe verticalement un support plan tel qu'un ruban 4, en carbone. Ce dernier comporte deux faces longitudinales 43, 44 et deux bords latéraux longitudinaux 41, 42 et sort du bain 2 en traversant sa surface d'équilibre horizontale 21. La largeur de l'ouverture 3 est déterminée pour que le ménisque de raccordement du silicium liquide soit stable dans cette ouverture 3, et par exemple vaut environ 600 µm. L'épaisseur du ruban de carbone 4 est typiquement d'environ 250 µm.

En fonctionnement, lorsque le ruban 4 se déplace dans le sens de la flèche 10, une couche 20 de silicium polycristallin se dépose sur les deux faces 43, 44 du ruban 4 à la sortie du bain 2.

Ce dispositif 100 comporte en outre deux éléments de contrôle des bords 5,5' maintenus sensiblement verticalement de part et d'autre des deux bords latéraux longitudinaux 41, 42.

Les conditions nominales du tirage de ruban sont définies par l'obtention, à une vitesse de tirage donnée, par exemple 810 cm/min, de filmes de silicium plans et d'épaisseur égale à une valeur prédéterminée constante par exemple 80-100 µm, dans leurs parties latérales et si possible jusque sur les bords.

Chacun des éléments de contrôle des bords 5, 5' comporte des parois 51 à 53, 51' à 53' délimitant une ouverture longitudinale 54, 54' qui borde individuellement l'un des bords latéraux longitudinaux 41, 42. Chaque ouverture est partiellement plongée dans le bain 2 de façon à élever le niveau du bain par capillarité à proximité du bord latéral longitudinal correspondant.

Pour chaque élément de contrôle des bords 5, 5',deux parois, dites d'insertion 51 à 52, 51' à 52', partiellement en regard de la face longitudinale 43, 44 correspondante du ruban 4 sont planes et par exemple parallèles.

Il est possible de contrôler la montée capillaire du silicium liquide le long des ouvertures en faisant varier les paramètres suivants :
- écartement et longueurs des parois d'insertion 51 à 52, 51' à 52',
- degré d'insertion par rapport aux bords 41, 42.

Ainsi il est possible, en ajustant ces paramètres, de relever l'isotherme de cristallisation sur les bords du ruban par rapport à une courbe qui serait obtenue avec un dispositif de l'art antérieur.

La profondeur de chaque ouverture 54, 54' est inférieure à 1 cm. L'écartement entre les parois d'insertion est inférieur à 7 mm.

Les éléments de contrôle 5, 5' ont été disposés par rapport aux bords 41, 42 du ruban de manière à obtenir une isotherme de cristallisation rectiligne sur toute la largeur du ruban 4.

Chacun des éléments de contrôle 5, 5' est fixe et maintenu verticalement par le fond 11. Plus précisément pour chacun d'eux, il s'agit d'une pièce rapportée qui s'étend longitudinalement et est fixée au fond 11 sur la face supérieure de la nervure 111, par exemple par une paire de vis 6, 6' en graphite (vis non visible représentée en pointillée sur la figure 2).

Ceci permet la réalisation de formes plus complexes et allège le coût de fabrication du creuset 1. Le matériau est différent ou non de celui du creuset. Il est choisi non réactif au silicium et avec une émissivité supérieure à l'émissivité du silicium.

Par ailleurs, les éléments de contrôle des bords 5, 5' présentent chacun au moins un orifice 7, 7' plongé dans le bain 2 et apte à l'alimentation en silicium, lequel de préférence est situé au voisinage du fond 11. En outre, le dispositif est représenté sans un couvercle.

Les éléments de contrôle des bords 5, 5' sont de préférence identiques et positionnés au même niveau par rapport aux bords 41, 42 et aux faces 43, 44 respectifs du ruban 4.

Bien entendu le dispositif 100 comporte, de plus, en pratique, des moyens de chauffage (non représentés) disposés autour du creuset 1 pour maintenir le silicium à l'état liquide.

Par ailleurs, les hauteurs H1, H2 du bain peuvent être régulées par des moyens appropriés par exemple à une valeur nominale plus ou moins 200 µm.

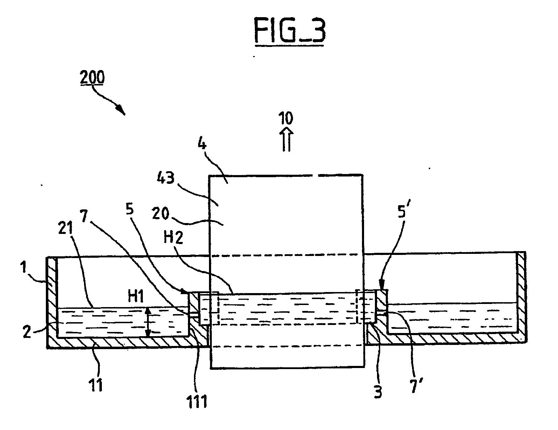

La figure 3 représente schématiquement un deuxième mode de réalisation d'un dispositif selon l'invention 200, coupé suivant un plan vertical.

Il s'agit d'une variante du premier mode de réalisation. Dans ce deuxième mode, les éléments de contrôle des bords 5, 5' s'étendent longitudinalement jusqu'au fond 11 et forment en outre une structure monolithique avec le fond 11.

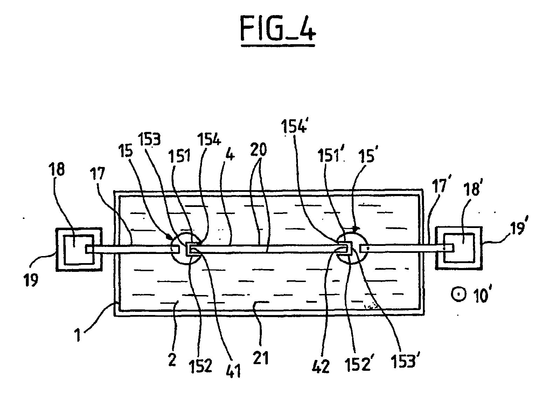

La figure 4 représente schématiquement un troisième mode de réalisation du dispositif selon l'invention 300, en vue de dessus.

Ce dispositif 200 comporte deux éléments de contrôle des bords 15, 15' maintenus sensiblement verticalement de part et d'autre des deux bords latéraux longitudinaux 41, 42.

Chacun des éléments de contrôle des bords 15, 15' comprend des parois 151 à 153, 151 à 153' délimitant une ouverture longitudinale 154, 154' qui borde l'un des bords latéraux longitudinaux 41, 42 du ruban 4. Chaque ouverture 154, 154' est partiellement plongée dans le bain 2 de façon à élever le niveau du bain par capillarité à proximité du bord latéral longitudinal correspondant 41, 42.

Plus précisément, chacun des éléments de contrôle des bords comprend deux plaquettes 15, 15' par exemple d'épaisseur de 1 mm environ et dont la surface horizontale inférieure est en contact avec la surface horizontale d'équilibre du bain 21 du bain 2 et est soulevée à un niveau prédéterminé au-dessus de cette surface d'équilibre 21.

Ces plaquettes 15, 15' sont en outre dotées des ouvertures 154, 154' ci-mentionnées. Ces plaquettes 15, 15' peuvent être par exemple circulaires et de diamètre effectif supérieur à 10 mm .

Les plaquettes 15, 15' sont en un matériau mouillable par le silicium liquide et ayant une émissivité supérieure à l'émissivité du silicium, par exemple le graphite.

Pour chaque élément de contrôle 15, 15', deux parois, dites d'insertion, 151 à 152, 151' à 152', partiellement en regard des faces longitudinales 41, 42 correspondantes, sont planes et par exemple parallèles.

L'écartement moyen entre les parois d'insertion est choisi de l'ordre de 2 mm.

Chaque plaquette 15, 15' est fixée sur un support. Par exemple, un point excentré de ces plaquettes est fixé à une extrémité d'une tige 17, 17' de préférence en graphite et en forme de potence. L'autre extrémité de chaque tige est fixée à la sortie 18, 18' d'un système mécanique 19, 19' capable de commander le déplacement des plaquettes de préférence uniquement suivant l'axe vertical 10', ce système étant disposé à l'extérieur du creuset 1.

Le contrôle des bords tel que décrit ci-dessus peut participer à l'augmentation du rendement de fabrication des plaques de silicium. Il présente aussi des avantages indéniables comme:
- un gain de surface exploitable : typiquement une largeur totale de 10 mm par face,
- la réalisation de dépôts de silicium sur un ruban de carbone, ces dépôts présentant relativement peu de fractures,
- l'amélioration des propriétés électriques des couches de silicium sur les bords, dont les grains présentent grâce à l'invention la sensiblement même texture que les grains de la partie latérale du dépôt.

Le dispositif selon la présente invention peut être appliqué à la réalisation de cellules photovoltaïques.

Bien entendu, l'invention n'est pas limitée aux modes de réalisation qui viennent d'être décrits.

## Revendications

1. Dispositif (100, 200, 300) pour déposer une couche (20) à base de silicium polycristallin sur un support (4) mobile, allongé, sensiblement plan, et comprenant deux faces longitudinales (43, 44) et deux bords latéraux longitudinaux (41, 42), comprenant :
- un creuset (1) contenant un bain (2) de silicium fondu, ledit support (4) étant destiné à être plongé au moins partiellement dans le bain et à traverser sensiblement verticalement dans le sens de la longueur la surface d'équilibre (21) du bain,
- au moins un élément de contrôle des bords (5, 5', 15, 15'), chaque élément de contrôle des bords étant maintenu sensiblement verticalement à proximité de l'un des deux bords latéraux longitudinaux (41, 42),
chaque élément de contrôle des bords comprenant des parois (51 à 53', 151 à 153') délimitant une ouverture longitudinale (54, 54', 154, 154') bordant le bord latéral longitudinal correspondant, chaque ouverture étant partiellement plongée dans le bain (2) de façon à élever le niveau du bain par capillarité à proximité du bord latéral longitudinal correspondant,
**caractérisé en ce que** au moins une des parois (51 à 52', 151 à 152'), dite d'insertion, partiellement en regard d'une des faces longitudinales est sensiblement plane.

2. Dispositif (100, 200, 300) pour déposer une couche à base de silicium polycristallin selon la revendication 1, comprenant
deux éléments de contrôle des bords, et dans lequel
chaque élément de contrôle des bords comprend deux parois d'insertion sensiblement planes.

3. Dispositif (100, 200, 300) pour déposer une couche à base de silicium polycristallin selon la revendication 2 **caractérisé en ce que** les parois d'insertion sont soit parallèles (51 à 52', 151 à 152') soit évasées vers l'extérieur.

4. Dispositif (100, 200, 300) pour déposer une couche à base de silicium polycristallin selon l'une des revendications 2 ou 3 **caractérisé en ce que** la profondeur moyenne de chaque ouverture (54 à 154') est inférieure à 1 cm.

5. Dispositif (100, 200, 300) pour déposer une couche à base de silicium polycristallin selon l'une des revendications 2 à 4 **caractérisé en ce que** l'écartement moyen entre les parois d'insertion (51 à 52', 151 à 152') est inférieur à 7 mm.

6. Dispositif (100, 200) pour déposer une couche à base de silicium polycristallin selon l'une des revendications 2 à 5 **caractérisé en ce que** le creuset (1) comportant un fond (11) et des parois latérales (12), chacun des éléments de contrôle des bords (5, 5') est fixe et maintenu verticalement par le fond.

7. Dispositif (100, 200) pour déposer une couche à base de silicium polycristallin selon l'une des revendications 2 à 5 **caractérisé en ce que** le creuset comportant un fond (11) et des parois latérales (12), chacun des éléments de contrôle des bords (5, 5') s'étend longitudinalement jusqu'au fond et de préférence forme une structure monolithique avec le fond.

8. Dispositif (100, 200) pour déposer une couche à base de silicium polycristallin selon la revendication 7 **caractérisé en ce que** chacun des éléments de contrôle des bords (5, 5') présente au moins un orifice (7, 7') plongé dans le bain (2) et apte à l'alimentation en silicium dudit élément, et de préférence millimétrique et situé au voisinage du fond.

9. Dispositif (300) pour déposer une couche à base de silicium polycristallin selon l'une des revendications 2 à 6 **caractérisé en ce que** chacun des éléments de contrôle des bords (15, 15') comprend une plaquette avec ladite ouverture (154, 154'), la plaquette étant amenée au contact de la surface d'équilibre (21) du bain.

10. Dispositif (300) pour déposer une couche à base de silicium polycristallin selon la revendication 9 **caractérisé en ce que** le contact de la surface du bain (21) est effectué par une liaison (17, 17') entre la plaquette et des moyens de déplacement extérieurs (19, 19') au creuset
(1) et de préférence autorisant uniquement un déplacement vertical.

11. Dispositif (300) pour déposer une couche à base de silicium polycristallin selon l'une des revendications 9 ou 10 **caractérisé en ce que** chaque plaquette (15, 15') comprend un disque avec ladite ouverture (154, 154') et présentant un diamètre effectif supérieur à 10 mm et de préférence de l'ordre de 12 mm.

12. Dispositif (300) pour déposer une couche à base de silicium polycristallin selon l'une des revendications 9 à 11 **caractérisé en ce que** l'écartement moyen entre les parois d'insertion (151 à 152') est de l'ordre de 2 mm.

13. Dispositif (100, 200, 300) pour déposer une couche à base de silicium polycristallin selon l'une des revendications 1 à 12 **caractérisé en ce que**, chacun des éléments de contrôle des bords (5, 5', 15, 15') est à base d'un matériau non réactif au silicium de préférence choisi parmi le graphite, le carbure de silicium et le nitrure de silicium.

14. Dispositif (100, 200, 300) pour déposer une couche à base de silicium polycristallin selon l'une des revendications 1 à 13 **caractérisé en ce que**, chacun des éléments de contrôle des bords (5, 5', 15, 15') est à base d'un matériau ayant une émissivité supérieure à l'émissivité du silicium.

## Claims

1. A device (100, 200, 300) for depositing a polycrystalline-silicon-based layer (20) on a movable, elongate, essentially planar support (4) having two longitudinal surfaces (43, 44) and two longitudinal lateral edges (41, 42), comprising:
- a crucible (1) containing a silicon-melt bath (2), said support (4) being designed to be dipped at least partially into the bath and traversing the equilibrium profile (21) of the bath in a substantially vertical manner in the direction of the length of the elongate support,
- at least one element for controlling the edges (5, 5', 15, 15'), each edge-control element being maintained in an essentially vertical position close to one of the two longitudinal lateral edges (41, 42),
each edge-control element comprising partition walls (51 to 53', 151 to 153') defining a longitudinal opening (54, 54', 154, 154') bordering on the corresponding longitudinal lateral edge, each opening being partially dipped in the bath (2) so as to raise the level of the bath by capillarity near the corresponding longitudinal lateral edge,
**characterized in that** at least one of the partition insertion walls (51 to 52', 151 to 152') partially opposite one of the longitudinal surfaces is essentially planar.

2. The device (100, 200, 300) for depositing a polycrystalline-silicon-based layer according to claim 1, comprising
two edge-control elements, and wherein each edge-control element comprises two essentially planar partition insertion walls.

3. The device (100, 200, 300) for depositing a polycrystalline-silicon-based layer according to claim 2, **characterized in that** the partition insertion walls are either parallel (51 to 52', 151 to 152') or outwardly flared.

4. The device (100, 200, 300) for depositing a polycrystalline-silicon-based layer according to one of claims 2 or 3 **characterized in that** the average depth of each opening (54 to 154') is less than 1 cm.

5. The device (100, 200, 300) for depositing a polycrystalline-silicon-based layer according to one of claims 2 to 4 **characterized in that** the average separation between the partition insertion walls (51 to 52', 151 to 152') is less than 7 mm.

6. The device (100, 200) for depositing a polycrystalline-silicon-based layer according to one of claims 2 to 5 **characterized in that** the crucible (1) comprising a bottom (11) and lateral walls (12), each of the edge-control elements (5, 5') is anchored and maintained vertically by the bottom.

7. The device (100, 200) for depositing a polycrystalline-silicon-based layer according to one of claims 2 to 5 **characterized in that** the crucible comprising a bottom (11) and lateral walls (12), each of the edge-control elements (5, 5') extends longitudinally to the bottom and preferably forms a monolithic structure with the bottom.

8. The device (100, 200) for depositing a polycrystalline-silicon-based layer according to claim 7 **characterized in that** each of the edge-control elements (5, 5') presents at least one orifice (7, 7') dipped in the bath (2) and capable of supplying said element with silicon, and preferably millimetric and situated in the vicinity of the bottom.

9. The device (300) for depositing a polycrystalline-silicon-based layer according to one of claims 2 to 6 **characterized in that** each of the edge-control elements (15, 15') comprises a wafer with said opening (154, 154'), the wafer being brought into contact with the equilibrium profile (21) of the bath.

10. The device (300) for depositing a polycrystalline-silicon-based layer according to claim 9 **characterized in that** the contact with the surface of the bath (21) is done by a connection (17, 17') between the wafer and exterior movement means (19, 19') to the crucible (1) and preferably allowing only a vertical movement.

11. The device (300) for depositing a polycrystalline-silicon-based layer according to one of claims 9 or 10 **characterized in that** each wafer (15, 15') comprises a disc with said opening (154, 154') and presenting an effective diameter greater than 10 mm and preferably in the vicinity of 12 mm.

12. The device (300) for depositing a polycrystalline-silicon-based layer according to one of claims 9 to 11 **characterized in that** the average separation between the partition insertion walls (151 to 152') is in the vicinity of 2 mm.

13. The device (100, 200, 300) for depositing a polycrystalline-silicon-based layer according to one of claims 1 to 12 **characterized in that** each of the edge-control elements (5, 5', 15, 15') has a base of a material not reactive to silicon preferably chosen among graphite, silicon carbide and silicon nitride.

14. The device (100, 200, 300) for depositing a polycrystalline-silicon-based layer according to one of claims 1 to 13 **characterized in that** each of the edge-control elements (5, 5', 15, 15') has a base of a material having an emissivity higher than the emissivity of the silicon.

## Patentansprüche

1. Vorrichtung (100, 200, 300) zum Abscheiden einer Schicht (20) auf Polysilizumbasis auf einer beweglichen, länglichen, im Wesentlichen ebenen Unterlage (4), die zwei Längsseiten (43, 44) und zwei längsgerichtete Seitenränder (41, 42) umfasst, wobei die Vorrichtung folgendes umfasst:
- einen Schmelztiegel (1), der ein Bad (2) mit geschmolzenem Silizium enthält, wobei die Unterlage (4) dazu gedacht ist, um mindestens teilweise in das Bad eingetaucht zu werden und die Gleichgewichtsfläche (21) des Bads in Längsrichtung im Wesentlichen senkrecht zu durchqueren,
- mindestens ein Element zum Steuern der Ränder (5, 5', 15, 15'), wobei jedes Randsteuerelement im Wesentlichen senkrecht in der Nähe eines der beiden längsgerichteten Seitenränder (41, 42) gehalten zu werden,
wobei jedes Randsteuerelement Wände (51 bis 53', 151 bis 153') umfasst, die eine Längsöffnung (54, 54', 154, 154') begrenzen, die den entsprechenden längsgerichteten Seitenrand einfasst, wobei jede Öffnung teilweise in das Bad (2) eingetaucht ist, um den Badspiegel durch Kapillarität in der Nähe des entsprechenden längsgerichteten Seitenrandes anzuheben,
**dadurch gekennzeichnet, dass** mindestens eine der Wände (51 bis 52', 151 bis 152'), eine so genannte Einschubwand, teilweise gegenüber einer der Längsseiten, im Wesentlichen eben ist.

2. Vorrichtung (100, 200, 300) zum Abscheiden einer Schicht auf Polysiliziumbasis nach Anspruch 1, umfassend zwei Randsteuerelemente, und wobei jedes Randsteuerelement zwei im Wesentlichen ebene Einschubwände umfasst.

3. Vorrichtung (100, 200, 300) zum Abscheiden einer Schicht auf Polysiliziumbasis nach Anspruch 2, **dadurch gekennzeichnet, dass** die Einschubwände entweder parallel (51 bis 52', 151 bis 152') oder nach außen aufgeweitet sind.

4. Vorrichtung (100, 200, 300) zum Abscheiden einer Schicht auf Polysiliziumbasis nach einem der Ansprüche 2 oder 3, **dadurch gekennzeichnet, dass** die durchschnittliche Tiefe jeder Öffnung (54 bis 154') kleiner als 1 cm ist.

5. Vorrichtung (100, 200, 300) zum Abscheiden einer Schicht auf Polysiliziumbasis nach einem der Ansprüche 2 bis 4, **dadurch gekennzeichnet, dass** der durchschnittliche Abstand zwischen den Einschubwänden (51 bis 52', 151 bis 152') kleiner als 7 mm ist.

6. Vorrichtung (100, 200) zum Abscheiden einer Schicht auf Polysiliziumbasis nach einem der Ansprüche 2 bis 5, **dadurch gekennzeichnet, dass** der Schmelztiegel (1) einen Boden (11) und Seitenwände (12) umfasst, wobei jedes der Elemente zum Steuern der Ränder (5, 5') ortsfest ist und senkrecht am Boden festgehalten wird.

7. Vorrichtung (100, 200) zum Abscheiden einer Schicht auf Polysiliziumbasis nach einem der Ansprüche 2 bis 5, **dadurch gekennzeichnet, dass** der Schmelztiegel einen Boden (11) und Seitenwände (12) umfasst, wobei jedes der Elemente zum Steuern der Ränder (5, 5') sich in Längsrichtung bis zum Boden erstreckt und bevorzugt eine mit dem Boden einstückige Struktur bildet.

8. Vorrichtung (100, 200) zum Abscheiden einer Schicht auf Polysiliziumbasis nach Anspruch 7, **dadurch gekennzeichnet, dass** jedes der Randsteuerelemente (5, 5') mindestens eine Öffnung (7, 7') aufweist, die in das Bad (2) eingetaucht wird und dazu geeignet ist, das Element mit Silizium zu versorgen, und die bevorzugt millimetergroß ist und sich in der Nähe des Bodens befindet.

9. Vorrichtung (300) zum Abscheiden einer Schicht auf Polysiliziumbasis nach einem der Ansprüche 2 bis 6, **dadurch gekennzeichnet, dass** jedes der Elemente zum Steuern der Ränder (15, 15') ein Plättchen mit der Öffnung (154, 154') umfasst,
wobei das Plättchen in Kontakt mit der Gleichgewichtsfläche (21) des Bads gebracht wird.

10. Vorrichtung (300) zum Abscheiden einer Schicht auf Polysiliziumbasis nach Anspruch 9, **dadurch gekennzeichnet, dass** der Kontakt mit der Oberfläche des Bads (21) über eine Verbindung (17, 17') zwischen dem Plättchen und Verschiebungsmitteln (19, 19') erfolgt, die außerhalb des Schmelztiegels (1) liegen und bevorzugt nur eine senkrechte Verschiebung zulassen.

11. Vorrichtung (300) zum Abscheiden einer Schicht auf Polysiliziumbasis nach einem der Ansprüche 9 oder 10, **dadurch gekennzeichnet, dass** jedes Plättchen (15, 15') eine Scheibe mit der Öffnung (154, 154') umfasst und einen tatsächlichen Durchmesser aufweist, der größer als 10 mm ist und bevorzugt etwa 12 mm beträgt.

12. Vorrichtung (300) zum Abscheiden einer Schicht auf Polysiliziumbasis nach einem der Ansprüche 9 bis 11, **dadurch gekennzeichnet, dass** der durchschnittliche Abstand zwischen den Einschubwänden (151 bis 152') ungefähr 2 mm beträgt.

13. Vorrichtung (100, 200, 300) zum Abscheiden einer Schicht auf Polysiliziumbasis nach einem der Ansprüche 1 bis 12, **dadurch gekennzeichnet, dass** jedes der Elemente zum Steuern der Ränder (5, 5', 15, 15') auf einem Material basiert, das nicht auf Silizium reaktionsfähig ist und bevorzugt aus Graphit, Siliziumcarbid und Siliziumnitrid gewählt wird.

14. Vorrichtung (100, 200, 300) zum Abscheiden einer Schicht auf Polysiliziumbasis nach einem der Ansprüche 1 bis 13, **dadurch gekennzeichnet, dass** jedes der Elemente zum Steuern der Ränder (5, 5', 15, 15') auf einem Material basiert, das ein Emissionsvermögen aufweist, das größer als das Emissionsvermögen des Siliziums ist.
